# EUROPEAN PATENT SPECIFICATION

(11) **EP 4 727 305 B1**
(45) Date of publication and mention of the grant of the patent: **14.10.2026**
(21) Application number: 24216372.3
(22) Date of filing: 29.11.2024
(51) Int. Cl.: H10H 29/01, H10H 29/30, H10H 29/85, H10H 29/853, H10H 29/855

(54) **TRANSPARENT DISPLAY AND MANUFACTURING METHOD THEREOF**
TRANSPARENTE ANZEIGE UND HERSTELLUNGSVERFAHREN DAFÜR
DISPOSITIF D'AFFICHAGE TRANSPARENT ET SON PROCÉDÉ DE FABRICATION

(30) Priority: 08.10.2024 CN 202411392746
(43) Date of publication of application: 15.04.2026
(73) Proprietor: Interface Technology (ChengDu) Co., Ltd., Chengdu City, Sichuan (CN); Interface Optoelectronics (Shenzhen) Co., Ltd., Shenzhen City, Guangdong 518109 (CN); General Interface Solution Limited, Miaoli County 350 (TW)
(72) Inventor: LIN, Po-Ching, Shenzhen City, Guangdong (CN); LAI, Wen-You, Shenzhen City, Guangdong (CN); KAO, Ping-Hsiang, Shenzhen City, Guangdong (CN)
(74) Representative: Balder IP Law, S.L.

(56) References cited:
- WO-A1-2023/226019
- CN-A- 115 472 730
- CN-A- 117 059 633
- US-A1- 2011 316 006
- US-A1- 2018 206 298
- US-A1- 2019 057 957
- US-A1- 2022 375 911
- US-A1- 2023 275 182

## Description

### BACKGROUND OF THE INVENTION

### Field of the Invention

The present invention relates to a transparent display, particularly to a transparent display and a manufacturing method thereof with high transparency and high brightness.

### Description of the Related Art

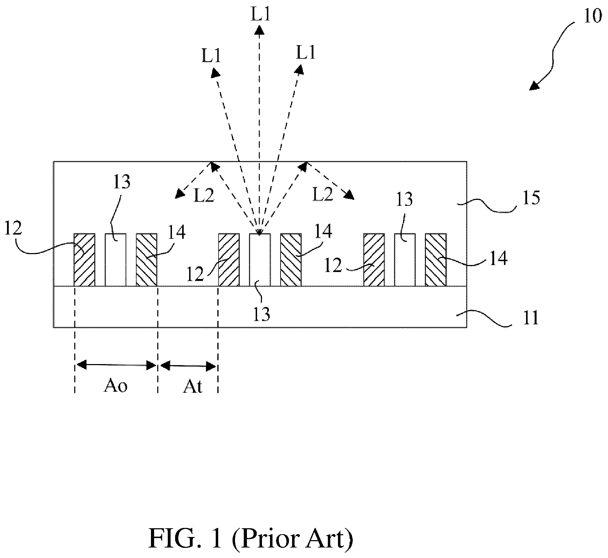

Fig.1 shows a conventional transparent display. The transparent display 10 of Fig.1 includes a transparent driving board 11, a plurality of light-emitting elements 12, 13, and 14, and a transparent encapsulation layer 15. The plurality of light-emitting elements 12, 13, and 14 are disposed on the transparent driving board 11. The transparent encapsulation layer 15 covers the plurality of light-emitting elements 12, 13, and 14. There are a plurality of metal lines and a plurality of thin film transistor elements (not shown) on the transparent driving board 11 for connecting and driving a plurality of light-emitting elements 12, 13, and 14, so that the light-emitting elements 12, 13, and 14 emit light L1 to the outside of the transparent display 10, thereby forming an image for the viewer to view. The light-emitting elements 12, 13, and 14 respectively emit light of different colors. For example, the light-emitting element 12 can emit red light, the light-emitting element 13 can emit green light, and the light-emitting element 14 can emit blue light. The light-emitting elements 12, 13, and 14 may be, but are not limited to, micro-light emitting diodes (micro LEDs). In Fig.1, the light-emitting elements 12, 13, and 14 are independent micro-light-emitting diode chips. In other embodiments, the light-emitting elements 12, 13 and 14 of different colors can also be integrated into the same micro-light emitting diode chip. The light-emitting elements 12, 13, and 14 and the plurality of metal lines and the plurality of thin film transistor elements of the transparent driving board 11 form an opaque area Ao, and the other parts form a light-transmitting area At.

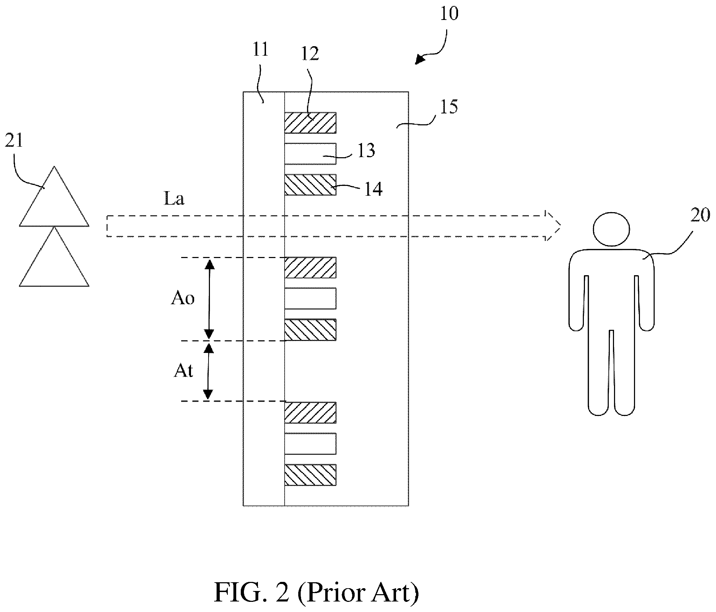

The transparent display 10 can allow external light La to penetrate. Thus, a viewer 20 can view a scene 21 in the back of the transparent display 10 from the front of the transparent display 10, as shown in Fig.2. In other words, the transparent display 10 allows the viewer 20 to view the scene 21 behind the transparent display 10 when viewing the screen information. Based on the transparent characteristics of the transparent display 10, the automobile industry thinks of attaching the transparent display 10 to the windshield of a vehicle or directly using the transparent display 10 to replace the original windshield, so that driving information (such as navigation instructions, vehicle speed, etc.) can be directly displayed on the windshield. Thus, the driver does not need to lower his head to confirm driving information, which helps avoid driver distraction. In other words, when the driver confirms driving information through the transparent display 10 on the windshield, he can also see the road conditions ahead, thus improving driving safety.

In addition to being used in automobiles, the transparent display 10 can also be used in many places. For example, replacing transparent windows or transparent glass with a transparent display 10 can make the display space more varied. Specifically, the transparent display 10 can be attached to or replaced by a store window, so that product information or the latest events can be displayed on the store window. Thus, consumers' attention can be quickly captured. In exhibition spaces such as museums and art galleries, the transparent display 10 can be attached to or replaced by the glass outside the exhibition, so that the concept of the work, the author's information, etc. can be presented in a dynamic manner, thereby increasing the interactive feeling of viewing the exhibition.

The transparent display 10 allows the user to view the scene behind the transparent display 10 when viewing screen information. Therefore, the transparent display 10 can also be applied to augmented reality (Augmented Reality; AR) glasses or devices. In the future, the transparent display 10 may even replace the lenses of glasses, so that the glasses not only have the function of correcting vision, but also can handle various things.

When the plurality of light-emitting elements 12, 13, and 14 are micro light-emitting diode chips, mass transfer can be used to arrange the plurality of light-emitting elements 12, 13, and 14 on the transparent driving board 11. After the mass transfer, the contact area between the micro light emitting diode chip and the transparent driving plate 11 is small, so the adhesion is also extremely small. Thus, they must be directly packaged to form a transparent encapsulation layer 15 to cover the micro light emitting diode chips, thereby improving the reliability of micro light emitting diode chips. However, the micro light-emitting diode chip is packaged in a bare die state. Thus, part of the light L2 emitted by the micro light-emitting diode chip will form total internal reflection instead of traveling to the outside of the transparent display 10, thereby reducing the light emission effect and causing the transparent display 10 to have insufficient brightness peaks, as shown in Fig.1.

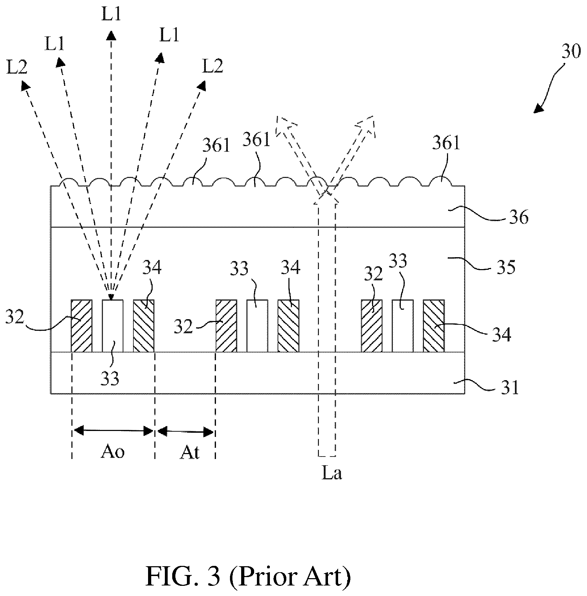

In order to improve the problem with insufficient brightness of transparent displays, some manufacturers have arranged a micro lens array (MLA) on the upper surface of the transparent encapsulation layer. Fig.3 shows a conventional transparent display with a micro lens array. The transparent display 30 of Fig.3 includes a transparent driving board 31, a plurality of light-emitting elements 32, 33, and 34, a transparent encapsulation layer 35, and a micro lens array layer 36. The plurality of light-emitting elements 32, 33, and 34 are disposed on the transparent driving board 31. The transparent encapsulation layer 35 covers the plurality of light-emitting elements 32, 33, and 34. The micro lens array layer 36 is attached to the upper surface of the transparent encapsulation layer 35. The transparent driving board 31 has a plurality of metal lines and a plurality of thin film transistor elements (not shown) for connecting and driving the plurality of light-emitting elements 32, 33, and 34. The light-emitting elements 32, 33 and 34 respectively emit light of different colors. For example, the light-emitting element 32 can emit red light, the light-emitting element 33 can emit green light, and the light-emitting element 34 can emit blue light. The light-emitting elements 32, 33, and 34 may be, but are not limited to, micro-light-emitting diodes. In Fig.1, the light-emitting elements 32, 33, and 34 are independent micro-light-emitting diode chips. In other embodiments, the light-emitting elements 12, 13, and 14 of different colors can also be integrated into the same micro-light emitting diode chip. The light-emitting elements 32, 33, and 34 and the plurality of metal lines and the plurality of thin film transistor elements of the transparent driving board 31 form an opaque area Ao, and the other parts form a light-transmitting area At. The micro lens array layer 36 is used to enhance the intensities of the light L1 and L2 emitted by the light-emitting elements 32, 33, and 34 to the outside of the transparent display 30, thereby increasing the peak brightness of the transparent display 30. In other words, the micro lens array layer 36 can improve the light emission effect of the transparent display 30. The micro lens array layer 36 has a micro lens array structure formed by a plurality of micro lenses 361 with clear apertures of microns. The shape profile of the micro lens 361 may be a regular shape or an irregular shape, where regular shapes include but are not limited to spherical, aspherical, cylindrical, hyperboloid, planar convex, and biconcave shapes. By adjusting the shape, focal length and arrangement of the micro lenses 361, the optical function of the micro lens array layer 36 can be adjusted. The material of the micro lens array layer 36 may be polydimethylsiloxane (PDMS), polymethylmethacrylate (PMMA), photoresist, or silicon dioxide (SiO₂).

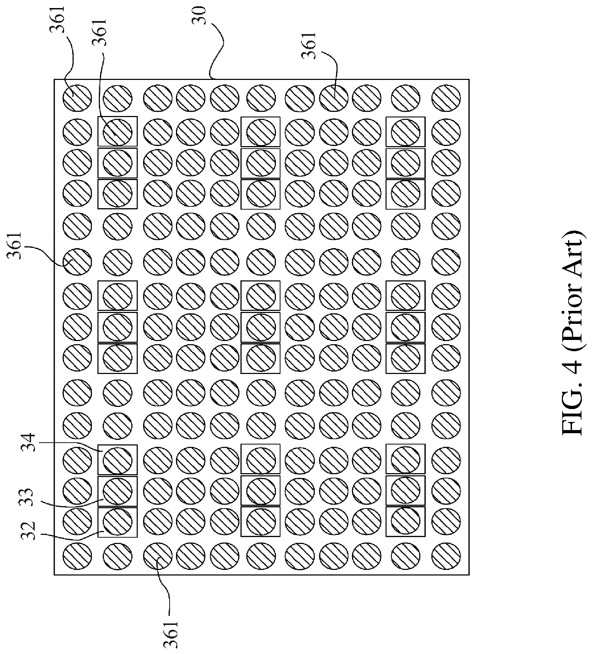

Generally speaking, compared with the transparent display 10 of Fig.1, the transparent display 30 of Fig.3 can increase the peak brightness by approximately 45% after adding the micro lens array layer 36. However, currently, the micro lenses 361 of the micro lens array layer 36 of the transparent display 30 occupy the entire micro lens array layer 36, as shown in Fig.4. In addition to being disposed above the opaque area Ao, the micro lens 361 is also disposed above the light-transmitting area At. Therefore, when the external light La enters the micro lens array layer 36 from the back of the transparent display 30 through the light-transmitting area At, the external light La will be scattered or focused and deformed by the micro lens 361, thus causing the scene 21 viewed by the viewer to be fogged or unclear. In other words, the micro lens array layer 36 decreases the transparency of the transparent display 30.

US 2023/275182 A1, CN 115472730 A, US 2022/375911 A1, WO 2023/226019 A1, US 2018/206298 A1 and CN 117059633 A disclose display devices including a transparent encapsulation layer having a micro lens array structure. In the case of CN 117059633 A, the micro lens array structure is only formed directly above photoreceptor elements of the display.

### SUMMARY OF THE INVENTION

One of objectives of the present invention is to provide a transparent display and a manufacturing method thereof with high transparency and high brightness.

According to the present invention, a transparent display as defined by claim 1 is provided.

In an embodiment, the plurality of light-emitting elements of the transparent display includes micro lighting-emitting diode chips.

According to the present invention, a manufacturing method of a transparent display as defined by claim 3 is provided.

In an embodiment, the transparent encapsulation layer and the micro lens array structure are formed in the same fabrication process.

In an embodiment, the plurality of light-emitting elements includes micro lighting-emitting diode chips.

In an embodiment, the micro lens array structure is formed by a method that includes thermal embossing, droplet jetting, photoresist thermal reflow, or laser.

The micro lenses of the micro lens array structure of the transparent display of the present invention do not cover the light-transmitting area of the transparent display. As a result, the transparent display of the present invention can have high transparency and high brightness.

Below, the embodiments are described in detail in cooperation with the drawings to make easily understood the technical contents, characteristics and accomplishments of the invention.

### BRIEF DESCRIPTION OF THE DRAWINGS

- Fig.1: is a diagram schematically illustrating a conventional transparent display;
- Fig.2: is a diagram schematically illustrating a viewer viewing a scene in the back of a transparent display;
- Fig.3: is a diagram schematically illustrating a conventional transparent display having a micro lens array;
- Fig.4: is a diagram schematically illustrating the arrangement of micro lenses of a micro lens array layer in Fig.3;
- Fig.5: is a diagram schematically illustrating a transparent display according to an embodiment of the present invention;
- Fig.6: is a diagram schematically illustrating the arrangement of micro lenses of a transparent encapsulation layer in Fig.5 according to a first embodiment of the present invention;
- Fig.7: is a diagram schematically illustrating the arrangement of micro lenses of a transparent encapsulation layer in Fig.5 according to a second embodiment of the present invention;
- Fig.8: is a diagram schematically illustrating the arrangement of micro lenses of a transparent encapsulation layer in Fig.5 according to a third embodiment of the present invention; and
- Fig.9: is a flowchart of a manufacturing method of a transparent display according to an embodiment of the present invention.

### DETAILED DESCRIPTION OF THE INVENTION

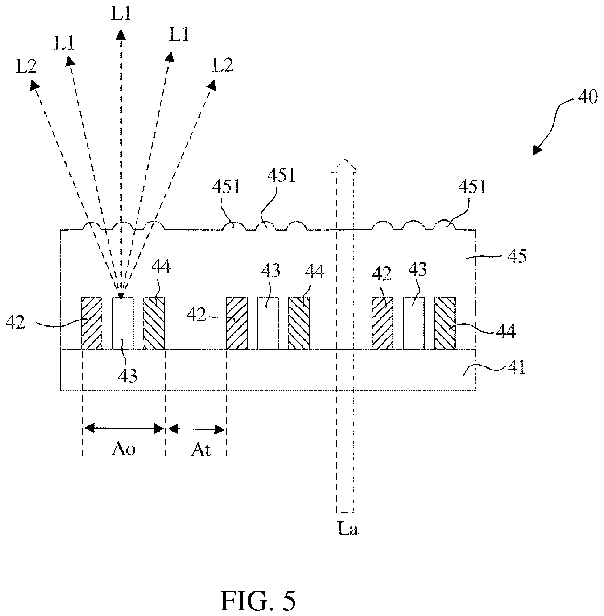

Fig.5 shows a transparent display of the present invention. The transparent display 40 of Fig.5 includes a transparent driving board 41, a plurality of light-emitting elements 42, 43, and 44 and a transparent encapsulation layer 45. The plurality of light-emitting elements 42, 43 and 44 are arranged on the transparent driving board 41, and the transparent encapsulation layer 45 covers the plurality of light-emitting elements 42, 43, and 44. There are a plurality of metal lines and a plurality of thin film transistor elements (not shown) on the transparent driving board 41 for connecting and driving the plurality of light-emitting elements 42, 43, and 44, so that the light-emitting elements 42, 43, and 44 emit light L1 and L2 to the outside of the transparent display 10 to form an image for the viewer to view. The light-emitting elements 42, 43 and 44 respectively emit light of different colors. For example, the light-emitting element 42 can emit red light, the light-emitting element 43 can emit green light, and the light-emitting element 44 can emit blue light. The light-emitting elements 42, 43, and 44 may be, but are not limited to, micro-light-emitting diodes. In Fig.5, the light-emitting elements 42, 43, and 44 are independent micro light-emitting diode chips. In other embodiments, the light-emitting elements 42, 43, and 44 of different colors can also be integrated into the same micro light emitting diode chip. The light-emitting elements 42, 43, and 44, the plurality of metal lines and the plurality of thin film transistor elements of the transparent driving board 41 form an opaque area Ao, and the other parts form a light-transmitting area At.

The transparent encapsulation layer 45 of Fig.5 has a micro lens array structure composed of a plurality of micro lenses 451. The micro lens array structure is used to increase the intensities of the light L1 and L2 emitted by the light-emitting elements 42, 43, and 44 to the outside of the transparent display 40, thereby increasing the peak brightness of the transparent display 40. In other words, the micro lens array structure composed of the micro lenses 451 can improve the light emission effect of the transparent display 40. The micro lenses 451 of the transparent encapsulation layer 45 have clear apertures of micros. The shape profile of the micro lens 451 may be a regular shape or an irregular shape, where regular shapes include but are not limited to circular, elliptical, spherical, aspheric, cylindrical, hyperboloid, planoconvex, and biconcave shapes. By adjusting the shape, focal length and arrangement of the micro lenses 4511, the optical function of the transparent encapsulation layer 45 can be adjusted.

In an embodiment, the transparent encapsulation layer 45 and the micro lens array structure composed of the micro lenses 451 can be formed in different fabrication processes. In one embodiment, the transparent encapsulation layer 45 and the micro lens array structure composed of the micro lenses 451 can be formed in the same fabrication process, thereby reducing the number of process steps.

In order to form the micro lens array structure, the micro lenses 451 are formed by thermal embossing, droplet jetting, photoresist thermal reflow, or laser, but the present invention is not limited thereto.

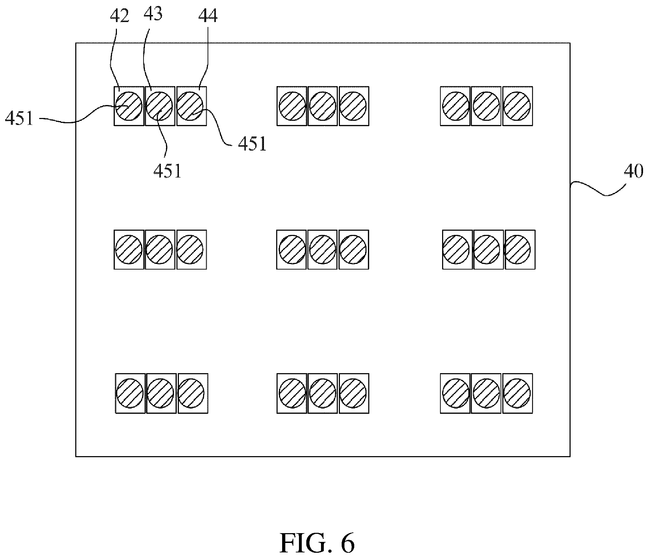

Fig.6 is a diagram schematically illustrating the arrangement of micro lenses of a transparent encapsulation layer in Fig.5 according to a first embodiment of the present invention. In accordance with the present invention, as shown in Fig.6, the micro lenses 451 are only formed directly above the light-emitting elements 42, 43, and 44. In other words, the micro lens array structure is only formed directly above each of the light-emitting elements 42, 43, and 44. Therefore, the light L1 and L2 emitted by the light-emitting elements 42, 43, and 44 can be emitted to the outside of the transparent display 40, thereby increasing the peak brightness of the transparent display 40. The micro lenses 451 of the micro lens array structure of the present invention are not arranged above the light-transmitting area At. As a result, after the external light La enters the transparent encapsulation layer 45 from the back of the transparent display 40 through the light-transmitting area At, the external light La It will not be scattered or focused and deformed by the micro lenses 451, and the viewer can clearly view the scene in the back of the transparent display 40. In other words, the transparent display 40 of the present invention not only has a brightness peak, but also has high transparency.

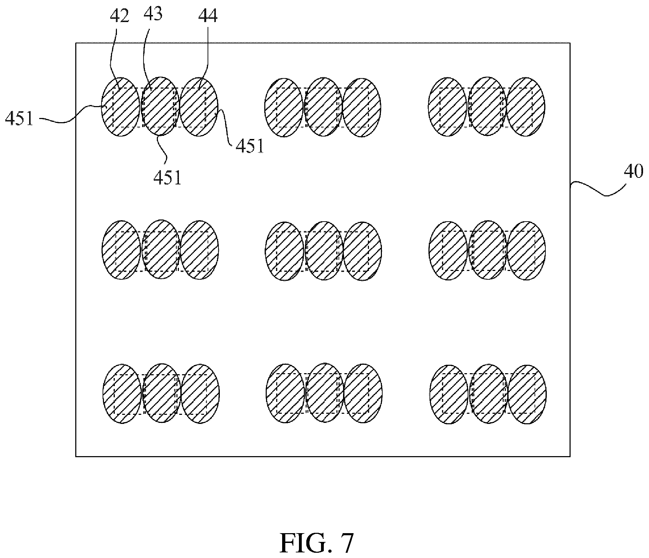

Fig.7 is a diagram schematically illustrating the arrangement of micro lenses of a transparent encapsulation layer in Fig.5 according to a second embodiment of the present invention. In the embodiment of Fig.7, the micro lenses 451 are arranged above the light-emitting elements 42, 43, and 44. The micro lenses 451 cover a small portion of the light-transmitting area At. Using the micro lenses 451 above the light-emitting elements 42, 43, and 44, the light L1 and L2 emitted by the light-emitting elements 42, 43, and 44 can be emitted to the outside of the transparent display 40, thereby increasing the peak brightness of the transparent display 40. When the external light La enters the transparent encapsulation layer 45 from the back of the transparent display 40 through the light-transmitting area At, the external light La is hardly affected by the micro lenses 451. Thus, the viewer can still clearly view the scene in the back of the transparent display 40. In other words, the transparent display 40 implemented with the embodiment of FIG. 7 still has a high brightness peak and high transparency.

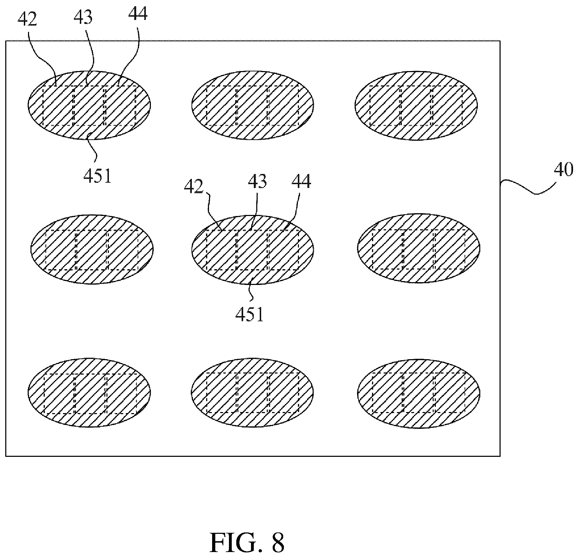

Fig.8 is a diagram schematically illustrating the arrangement of micro lenses of a transparent encapsulation layer in Fig.5 according to a third embodiment of the present invention. In the embodiment of Fig.8 , one micro lens 451 covers a group of light-emitting elements 42, 43, and 44 and covers a small portion of the light-transmitting area At. The light L1 and L2 emitted by the light-emitting elements 42, 43, and 44 can be emitted to the outside of the transparent display 40 through the upper micro lenses 451, thereby increasing the peak brightness of the transparent display 40. When the external light La enters the transparent encapsulation layer 45 from the back of the transparent display 40 through the light-transmitting area At, the external light La is hardly affected by the micro lenses 451. Thus, the viewer can still clearly view the scene in the back of the transparent display 40. In other words, the transparent display 40 implemented with the embodiment of Fig.8 still has a high brightness peak and high transparency.

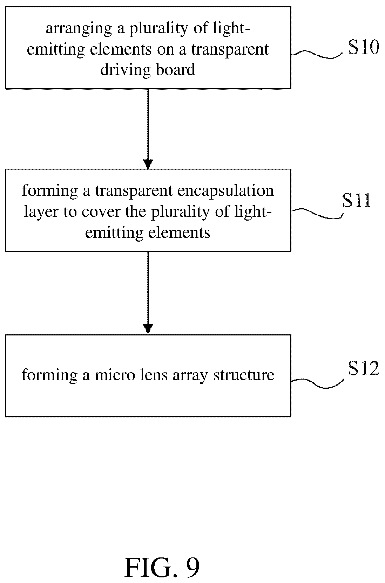

Fig.9 is a flowchart of a manufacturing method of a transparent display according to an embodiment of the present invention. Referring to Figs.5 and 9, the manufacturing method of the transparent display 40 of the present invention includes Step S10. In Step S10, a plurality of light-emitting elements 42, 43, and 44 are arranged on the transparent driving plate 41. Assume that the plurality of light-emitting elements 42, 43, and 44 are micro light-emitting diode chips. Mass transfer can be used to arrange the plurality of light-emitting elements 42, 43, and 44 on the transparent driving board 41 in Step S10.

After the light-emitting elements 42, 43, and 44 are arranged on the transparent driving board 41, Step S11 is performed. In Step S11, the contact area between the micro light emitting diode chip and the transparent driving board 41 is small and thus their adhesion force is also extremely small. Therefore, after arranging the light-emitting elements 42, 43, and 44 on the transparent driving board 41, they must be directly packaged to form a transparent encapsulation layer 45 to cover the micro light-emitting diode chip, thereby improving the reliability of the micro light-emitting diode chip.

After the transparent encapsulation layer 45 is formed to cover the light-emitting elements 42, 43, and 44, Step S12 is performed. Since the micro light-emitting diode chip is packaged in a bare die state, part of the light L2 emitted by the micro light-emitting diode chip may form total internal reflection instead of traveling to the outside of the transparent display 40. In order to improve the light emission effect of the transparent display 40, a micro lens array structure is formed on the local surface of the transparent encapsulation layer 45 above the light-emitting elements 42, 43, and 44 in Step S12. In Step S12, a plurality of micro lenses 451 can be formed by, but not limited to, thermal embossing, droplet ejection, photoresist thermal reflow, or laser to form the lens array structure.

In accordance with the present invention, Step S12 only forms micro lenses 451 on the surface of the transparent encapsulation layer 45 directly above the light-emitting elements 42, 43, and 44. That is to say, the micro lens array structure only covers the opaque area. Ao. In an example not forming part of the present invention, Step S12 may form the micro lenses 451 above the light-emitting elements 42, 43, and 44, and the micro lenses 451 cover a small portion of the light-transmitting area At.

In one embodiment, Steps S11 and S12 are performed in different fabrication processes. That is to say, the transparent encapsulation layer 45 and the micro lens array structure composed of the plurality of micro lenses 451 are formed in different fabrication processes. In one embodiment, Steps S11 and S12 are performed in the same fabrication process. That is to say, the transparent encapsulation layer 45 and the micro lens array structure composed of the plurality of micro lenses 451 can be formed in the same fabrication process, thereby reducing the number of manufacturing steps.

Take a 13.3-inch transparent display as an example to conduct experiments. Under the same conditions, compared with the transparent display 10 of Fig.1, the transparent display 40 of the present invention can increase the peak brightness by up to 243%. The transparency of the transparent display 40 of the present invention can be only 3% lower than the transparency of the transparent display 10 of Fig.1. Therefore, compared with the transparent display 10 of Fig.1, the transparent display 40 of the present invention can indeed have the advantages of high transparency and high brightness.

In the transparent display 30 of Fig.3, both the light L1 and L2 emitted by the light-emitting elements 32, 33, and 34 and the external light La need to pass through the transparent encapsulation layer 35 and the micro lens array layer 36. Since the transparent encapsulation layer 35 and the micro lens array layer 36 are different media, the light L1 and L2 or the external light La will lose energy during transmission, thereby decreasing the peak brightness. On the contrary, in the transparent display 40 of the present invention, the light L1 and L2 emitted by the light-emitting elements 42, 43, and 44 as well as the external light La only need to pass through the transparent encapsulation layer 45. Thus, the energy lost is small when the light is transmitted and the transparent display 30 has a higher brightness peak. In addition, in the transparent display 30 of Fig.3 , the micro lenses 361 of the micro lens array layer 36 cover most of the light-transmitting area At, thereby causing the external light La to be scattered or focused and deformed by the micro lenses 361 and reducing the transparency of the transparent display 30. On the contrary, in the transparent display 40 of the present invention, the micro lenses 451 of the micro lens array structure on the surface of the transparent encapsulation layer 45 are almost only arranged in the opaque area Ao. Accordingly, the external light La can almost directly pass through the transparent display. 40 without being affected, thereby improving the transparency of the transparent display 40. Therefore, compared with the transparent display 30 of Fig.3, the transparent display 40 of the present invention can indeed have the advantages of high transparency and high brightness.

The embodiments described above are only to exemplify the invention but not to limit the scope of the invention. Therefore, any equivalent modification or variation according to the shapes, structures, or features disclosed by the embodiments is to be also included within the scope of the invention as defined by the claims.

## Claims

1. A transparent display (40) comprising:
a transparent driving board (41);
a plurality of light-emitting elements (42, 43, 44) arranged on the transparent driving board (41); and
a transparent encapsulation layer (45) covering the plurality of light-emitting elements (42, 43, 44), wherein a surface of the transparent encapsulation layer (45) above the plurality of light-emitting elements (42, 43, 44) has a micro lens array structure (451) and
wherein the micro lens array structure (451) is only formed directly above each of the plurality of light-emitting elements (42, 43, 44).

2. The transparent display (40) according to claim 1, wherein the plurality of light-emitting elements (42, 43, 44) includes micro lighting-emitting diode chips.

3. A manufacturing method of a transparent display (40) comprising:
arranging a plurality of light-emitting elements (42, 43, 44) on a transparent driving board (41);
forming a transparent encapsulation layer (45) to cover the plurality of light-emitting elements (42, 43, 44); and
forming a micro lens array structure (451) on a surface of the transparent encapsulation layer (45) above the plurality of light-emitting elements (42, 43, 44) and
wherein the micro lens array structure (451) is only formed directly above each of the plurality of light-emitting elements (42, 43, 44).

4. The manufacturing method according to claim 3, wherein the transparent encapsulation layer (45) and the micro lens array structure (451) are formed in a same fabrication process.

5. The manufacturing method according to claim 3, wherein the plurality of light-emitting elements (42, 43, 44) includes micro lighting-emitting diode chips.

6. The manufacturing method according to claim 3, wherein the micro lens array structure (451) is formed by a method that includes thermal embossing, droplet jetting, photoresist thermal reflow, or laser.

## Patentansprüche

1. Transparente Anzeige (40), umfassend:
eine transparente Ansteuerplatine (41);
eine Vielzahl von lichtemittierenden Elementen (42, 43, 44), die auf der transparenten Ansteuerplatine (41) angeordnet sind; und
eine transparente Verkapselungsschicht (45), die die Vielzahl von lichtemittierenden Elementen (42, 43, 44) bedeckt,
wobei eine Oberfläche der transparenten Verkapselungsschicht (45) über der Vielzahl von lichtemittierenden Elementen (42, 43, 44) eine Mikrolinsenarraystruktur (451) aufweist, und
wobei die Mikrolinsenarraystruktur (451) nur unmittelbar über jedem lichtemittierenden Element der Vielzahl von lichtemittierenden Elementen (42, 43, 44) ausgebildet ist.

2. Transparente Anzeige (40) nach Anspruch 1, wobei die Vielzahl von lichtemittierenden Elementen (42, 43, 44) Mikro-Leuchtdiodenchips umfasst.

3. Herstellungsverfahren für eine transparente Anzeige (40), umfassend:
Anordnen einer Vielzahl von lichtemittierenden Elementen (42, 43, 44) auf einer transparenten Ansteuerplatine (41);
Bilden einer transparenten Verkapselungsschicht (45), um die Vielzahl von lichtemittierenden Elementen (42, 43, 44) zu bedecken; und
Bilden einer Mikrolinsenarraystruktur (451) auf einer Oberfläche der transparenten Verkapselungsschicht (45) über der Vielzahl von lichtemittierenden Elementen (42, 43, 44), und
wobei die Mikrolinsenarraystruktur (451) nur unmittelbar über jedem lichtemittierenden Element der Vielzahl von lichtemittierenden Elementen (42, 43, 44) ausgebildet wird.

4. Herstellungsverfahren nach Anspruch 3, wobei die transparente Verkapselungsschicht (45) und die Mikrolinsenarraystruktur (451) in demselben Fertigungsprozess gebildet werden.

5. Herstellungsverfahren nach Anspruch 3, wobei die Vielzahl von lichtemittierenden Elementen (42, 43, 44) Mikro-Leuchtdiodenchips umfasst.

6. Herstellungsverfahren nach Anspruch 3, wobei die Mikrolinsenarraystruktur (451) durch ein Verfahren gebildet wird, das thermisches Prägen, Tröpfchenausstoß, thermisches Verfließen von Fotolack oder Laser umfasst.

## Revendications

1. Affichage transparent (40) comprenant :
une carte de commande transparente (41) ;
une pluralité d'éléments électroluminescents (42, 43, 44) agencés sur la carte de commande transparente (41) ; et
une couche d'encapsulation transparente (45) recouvrant la pluralité d'éléments électroluminescents (42, 43, 44), dans lequel une surface de la couche d'encapsulation transparente (45) au-dessus de la pluralité d'éléments électroluminescents (42, 43, 44) a une structure de réseau de microlentilles (451) et
dans lequel la structure de réseau de microlentilles (451) est formée uniquement directement au-dessus de chacun de la pluralité d'éléments électroluminescents (42, 43, 44).

2. Affichage transparent (40) selon la revendication 1, dans lequel la pluralité d'éléments électroluminescents (42, 43, 44) comporte des puces de micro-diode électroluminescente.

3. Méthode de fabrication d'un affichage transparent (40) comprenant les étapes suivantes :
agencer une pluralité d'éléments électroluminescents (42, 43, 44) sur une carte de commande transparente (41) ;
former une couche d'encapsulation transparente (45) pour recouvrir la pluralité d'éléments électroluminescents (42, 43, 44) ; et
former une structure de réseau de microlentilles (451) sur une surface de la couche d'encapsulation transparente (45) au-dessus de la pluralité d'éléments électroluminescents (42, 43, 44) et
dans laquelle la structure de réseau de microlentilles (451) est formée uniquement directement au-dessus de chacun de la pluralité d'éléments électroluminescents (42, 43, 44).

4. Méthode de fabrication selon la revendication 3, dans laquelle la couche d'encapsulation transparente (45) et la structure de réseau de microlentilles (451) sont formées au cours d'un même procédé de fabrication.

5. Méthode de fabrication selon la revendication 3, dans laquelle la pluralité d'éléments électroluminescents (42, 43, 44) comporte des puces de micro-diode électroluminescente.

6. Méthode de fabrication selon la revendication 3, dans laquelle la structure de réseau de microlentilles (451) est formée par une méthode qui comporte le gaufrage thermique, la projection de gouttelettes, la refusion thermique de photorésist ou le laser.
